(19) Europäisches Patentamt
European Patent Office
Office européen des brevets

(11) **EP 4 387 418 B1**

(12) **EUROPEAN PATENT SPECIFICATION**

(45) Date of publication and mention
of the grant of the patent:
**18.03.2026   Bulletin 2026/12**

(21) Application number: **21960996.3**

(22) Date of filing: **21.10.2021**

(51) International Patent Classification (IPC):
*H10K 50/85* (2023.01)      *H10K 59/00* (2023.01)
*H10K 50/80* (2023.01)      *G02B 5/00* (2006.01)
*H10K 59/35* (2023.01)      *H10K 50/858* (2023.01)
*H10K 59/80* (2023.01)      *H10K 102/00* (2023.01)

(52) Cooperative Patent Classification (CPC):
**H10K 59/879; G02B 5/00;** H10K 59/35;
H10K 59/38; H10K 59/80; H10K 59/875;
H10K 2102/00; H10K 2102/3023; H10K 2102/351

(86) International application number:
**PCT/CN2021/125420**

(87) International publication number:
**WO 2023/065247 (27.04.2023 Gazette 2023/17)**

(54) **DISPLAY MODULE AND PREPARATION METHOD THEREFOR, AND DISPLAY DEVICE**

ANZEIGEMODUL UND HERSTELLUNGSVERFAHREN DAFÜR SOWIE ANZEIGEVORRICHTUNG

MODULE D'AFFICHAGE ET SON PROCÉDÉ DE PRÉPARATION ET DISPOSITIF D'AFFICHAGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**19.06.2024   Bulletin 2024/25**

(73) Proprietors:
• **BOE Technology Group Co., Ltd.
Chaoyang District,
Beijing 100015 (CN)**
• **Yunnan Invensight Optoelectronics
Technology Co., Ltd.
Kunming, Yunnan 650211 (CN)**

(72) Inventors:
• **ZHU, Zhijian
Beijing 100176 (CN)**
• **LU, Pengcheng
Beijing 100176 (CN)**
• **YANG, Shengji
Beijing 100176 (CN)**
• **HUANG, Kuanta
Beijing 100176 (CN)**
• **CHEN, Xiaochuan
Beijing 100176 (CN)**
• **WU, Qian
Beijing 100176 (CN)**
• **FAN, Longfei
Beijing 100176 (CN)**
• **ZHANG, Dacheng
Beijing 100176 (CN)**

(74) Representative: **Potter Clarkson
Chapel Quarter
Mount Street
Nottingham NG1 6HQ (GB)**

(56) References cited:
WO-A1-2020/162355      CN-A- 104 167 420
CN-A- 108 169 921      CN-A- 110 764 169
CN-A- 110 783 367      CN-A- 113 241 354
JP-A- 2000 241 809      JP-A- 2004 070 283
JP-A- 2006 323 149      US-A1- 2010 157 424
US-A1- 2020 358 034

## Description

TECHNICAL FIELD

The present disclosure relates to the field of display technology, and in particular, to a display module, a method for preparing the display module, and a display device including the display module.

BACKGROUND

A micro-organic light-emitting diode (Micro-OLED) display has the advantages of small volume, light weight, high contrast, fast response speed, and low power consumption, etc. However, the Micro-OLED display generally has the problem of low light-emitting brightness, thereby limiting the widespread application of the Micro-OLED display in various fields.

It should be noted that the information disclosed in the above background part is only used to enhance the understanding of the background of the present disclosure, and therefore may include information that does not constitute related art known to those of ordinary skill in the art.

WO 2020/162355 A1 discloses a light emitting element that comprises: a light emitting unit; an intermediate layer which covers the light emitting unit, an optical path control means provided on or above the intermediate layer, and a coating layer which covers at least the optical path control means. The light emitted from the light emitting unit passes through the intermediate layer, enters the optical path control means, and exits from the optical path control means. The coating layer is composed of a first coating layer and a second coating layer. The first coating layer covers a part of the outer surface of the optical path control means on the intermediate layer side. The second coating layer covers the first coating layer and the rest of the outer surface of the optical path control means. A value n0 of the refractive index of a material forming the optical path control means, a value n1 of the refractive index of a material forming the first coating layer, and a value n2 of the refractive index of a material forming the second coating layer are different from each other.

US 2020/358034 A1 discloses a display device that includes a substrate, a lens layer including a plurality of lenses, and a plurality of pixel electrodes disposed between the substrate and the lens layer. The plurality of pixel electrodes include a first pixel electrode and a second pixel electrode. The plurality of lenses include a first lens disposed correspondingly to the first pixel electrode and a second lens disposed correspondingly to the second pixel electrode. An area of the first pixel electrode in plan view is greater than an area of the second pixel electrode in the plan view. An area of the first lens in the plan view is greater than an area of the second lens.

SUMMARY

An objective of the present disclosure is to overcome the defects in the related art, and provide a display module, a method for preparing the display module, and a display device including the display module.

According to an aspect of the present disclosure, there is provided a display module, including:

a display panel;
a color film layer, provided on a light-emitting side of the display panel, where the color film layer includes a plurality of light-filtering portions; and
a micro-lens layer, provided on a side of the color film layer away from the display panel; where, the micro-lens layer includes a plurality of first converging lenses and a plurality of second converging lenses, a gap is provided between two adjacent first converging lenses, and an orthographic projection of a first converging lens on the display panel is located within an orthographic projection of a light-filtering portion on the display panel; a second converging lens is provided in the gap between two adjacent first converging lenses, and the second converging lens is connected to the first converging lens.

In an example embodiment, an overlapping portion is provided between two adjacent light-filtering portions, and an orthographic projection of the overlapping portion on the display panel overlaps with an orthographic projection of the second converging lens on the display panel.

In an example embodiment, on a cross section of the overlapping portion perpendicular to the display panel, an orthographic projection of a highest point of the overlapping portion away from the display panel on the display panel is located within the orthographic projection of the second converging lens on the display panel.

In an example embodiment, a width of the second converging lens is less than 1/10 of a width of the first converging lens, and a height of the second converging lens is less than 1/10 of a height of the first converging lens.

In an example embodiment, the display panel includes:

a substrate layer;
a first electrode, provided on a side of the substrate layer close to the color film layer;
a light-emitting layer, provided on a side of the first electrode away from the substrate layer; and
a second electrode, provided on a side of the light-emitting layer away from the substrate layer;
where an orthographic projection of the second converging lens on the substrate layer is at least partially located within a projection of an edge portion of the first electrode on the substrate layer.

In an example embodiment, the second electrode includes a flat portion and a lower concave portion, and the orthographic projection of the second converging lens on the substrate layer is located within a projection of the lower concave portion on the substrate layer.

In an example embodiment, a width of the first converging lens is greater than a maximum width of the first electrode.

In an example embodiment, a height of the second converging lens is less than an interval between two adjacent first electrodes.

In an example embodiment, an orthographic projection of the first converging lens on the substrate layer is located within an orthographic projection of the light-emitting layer on the substrate layer.

In an example embodiment, the first converging lens is configured as a spherical segment structure, and the second converging lens is configured as a spherical segment structure.

In an example embodiment, the micro-lens layer further includes:

a first flat plate layer, provided between the color film layer and the first converging lens; and
a second flat plate layer, provided between the color film layer and the second converging lens, where the second flat plate layer is integrally connected to the first flat plate layer.

In an example embodiment, the first converging lens and the second converging lens satisfy a following relationship:

$$D\text{-}d = (P\text{-}s)/2,$$

where $P$ is a width of the light-filtering portion in a first direction, s is a width of the gap in the first direction, $D$ is a sum of a height of the first converging lens and a height of the first flat plate layer, and $d$ is a sum of a height of the second converging lens and a height of the second flat plate layer.

In an example embodiment, a thickness and a refractive index of each film layer between a light-emitting surface of the display panel and the micro-lens layer satisfy a following relationship:

$$L = \Sigma\, Lini \approx (P\text{-}s)/[2 \times (n-1)],$$

where $L$ is a light path between the light-emitting surface of the display panel and a surface of the micro-lens layer close to the display panel, $n$ is a refractive index of the first converging lens, $Li$ is the thickness of each film layer between the light-emitting surface of the display panel and the micro-lens layer, and $ni$ is the refractive index of each film layer between the light-emitting surface of the display panel and the micro-lens layer.

**In** an example embodiment, the display module further includes:

a first planarization layer, provided between the display panel and the color film layer; and
a second planarization layer, provided between the color film layer and the micro-lens layer.

According to another aspect of the present disclosure, there is provided a method for preparing a display module, including:

providing a display panel;
forming a color film layer on a light-emitting side of the display panel, where the color film layer includes a plurality of light-filtering portions; and
forming a micro-lens layer on a side of the color film layer away from the display panel, where the micro-lens layer includes a plurality of first converging lenses and a plurality of second converging lenses; a gap is provided between two adjacent first converging lenses, an orthographic projection of a first converging lens on the display panel is located within an orthographic projection of a light-filtering portion on the display panel, a second converging lens is formed in the gap between two adjacent first converging lenses, and the second converging lens is connected to the first converging lens.

In an example embodiment, a first flat plate layer and a second flat plate layer are formed while forming the first converging lens and the second converging lens, the first flat plate layer is formed between the color film layer and the first converging lens, the second flat plate layer is formed between the color film layer and the second converging lens, and the second flat plate layer is connected to the first flat plate layer.

In an example embodiment, forming the micro-lens layer on the side of the color film layer away from the display panel includes:
forming a micro-lens material layer on the side of the color film layer away from the display panel, then forming a preset pattern layer by performing patterned processing on the micro-lens material layer, and then forming the first converging lens, the second converging lens, the first flat plate layer and the second flat plate layer by baking the preset pattern layer.

In an example embodiment, a baking temperature is greater than or equal to 100° C and less than or equal to 130° C, and a baking time is greater than or equal to 50 minutes and less than or equal to 70 minutes.

According to yet another aspect of the present disclosure, there is provided a display device including any of the above display module.

The display module of the present disclosure includes a display panel, a color film layer and a micro-lens layer which are sequentially stacked; the color film layer includes a plurality of light-filtering portions, and the micro-lens layer includes a plurality of first converging lenses and a plurality of second converging lenses; a gap is provided between two adjacent first converging lenses, an orthographic projection of a first converging lens on the display panel is located within an orthographic projection of a light-filtering portion on the display panel, a second converging lens is provided in the gap between two adjacent first converging lenses, and the second converging lens is connected to the first converging lens. The light emitted from the light-filtering portion may be converged by the first converging lens, so that the diffusion angle of the light emitted from the first converging lens is small, thus improving the display brightness within an effective viewing angle. When there is provided a gap between two adjacent first converging lenses, the preparation process of the first converging lens can make the shape of the first converging lens more standard, thus ensuring the converging effect on the light and further improving the brightness. The second converging lens may converge the light emitted into the gap between two adjacent first converging lenses, thus further improving the brightness of the display module.

It should be understood that the above general description and the following detailed description are exemplary and explanatory only and are not intended to limit the present disclosure.

BRIEF DESCRIPTION OF THE DRAWINGS

The accompanying drawings here, which are incorporated in and constitute a part of the description, illustrate embodiments consistent with the disclosure and together with the description serve to explain the principles of the disclosure. Obviously, the drawings in the following description are some embodiments of the present disclosure, and for those of ordinary skill in the art, other drawings can also be obtained from these drawings without creative efforts.

FIG. 1 is a schematic structural diagram of a display module according to an example embodiment of the present disclosure.

FIG. 2 is a schematic top view of the color film layer in FIG. 1.

FIG. 3 is a schematic diagram showing a relative position of the color film layer and the light-emitting unit in FIG. 1.

FIG. 4 is a schematic diagram showing the relative positions of the micro-lens layer, the color film layer and the light-emitting unit in FIG. 1.

FIG. 5 is a schematic diagram of a light path of the micro-lens layer in FIG. 1.

FIG. 6 is a schematic diagram of a size relationship of the micro-lens layer in FIG. 1.

FIG. 7 is a schematic flowchart of a method for preparing a display module according to an example embodiment of the present disclosure.

Description of the reference numerals:

1, Display panel; 11, Substrate layer; 12, Back plate; 13, Third planarization layer; 14, First electrode; 141, Metal layer; 142, Transparent conductive layer; 143, Edge portion; 15, Pixel dielectric layer; 16, Light-emitting layer; 17, Second electrode; 171, Flat portion; 172, Lower concave portion; 18, Light-emitting unit;

2, Thin film encapsulation; 3, First planarization layer;

4, Color film layer; 41, Red light-filtering portion; 42, Green light-filtering portion; 43, Blue light-filtering portion; 44, Overlapping portion; 4a, Light-filtering portion;

5, Second planarization layer;

6, Micro-lens layer; 61, First converging lens; 62, Second converging lens; 63, First flat plate layer; 64, Second flat plate layer; 65, Gap;

7, Adhesive layer; 8, Cover plate.

DETAILED DESCRIPTION

Example embodiments will now be described more fully with reference to the accompanying drawings. Example embodiments, however, can be implemented in various forms and should not be construed as limited to the embodiments set forth herein; by contrast, these embodiments are provided so that the present disclosure will be thorough and complete, and will fully convey the concept of example embodiments to those skilled in the art. The same reference numerals in the drawings denote the same or similar structures, and thus their detailed descriptions will be omitted. In addition, the drawings are merely schematic illustrations of the present disclosure, and are not necessarily drawn to scale.

Although relative terms such as "upper" and "lower" are used in the description to describe the relative relationship of one component to another component shown in the drawings, these terms are used in the description only for convenience, for example, according to the directions shown in the accompanying drawings. It will be appreciated that if the device shown in the drawings is turned over so that it is upside down, then the component described as being "upper" will become the component that is "lower". When a structure is "on" another structure, it may mean that a structure is integrally formed on another structure, or that a structure is "directly" placed on another structure, or that a structure is "indirectly" placed on another structure through another structure.

The terms "a", "an", "the", "said" and "at least one" are used to indicate the presence of one or more elements/components/etc.; the terms "comprising" and "including" are used to indicate an open inclusion and means that there may be additional elements/components/etc. in addition to the listed elements/components/etc.; the terms "first", "second" and "third" etc. are only used as a marker, not a limit on the number of its objects.

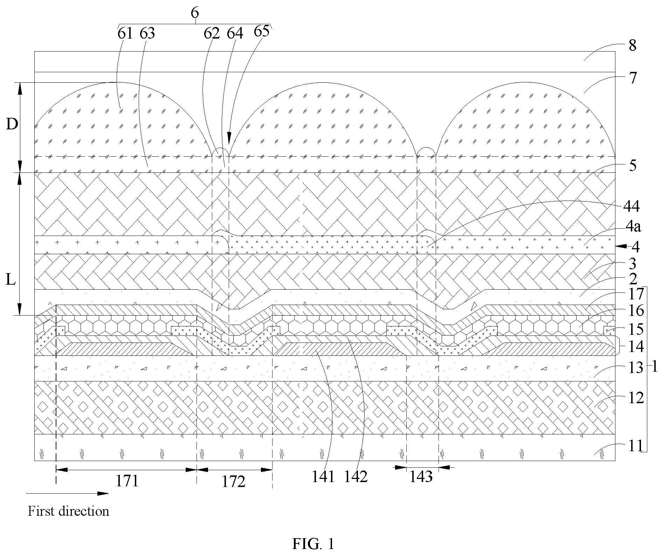

According to an example embodiment of the present disclosure, there is provided a display module. Referring to FIG. 1 to FIG. 6, the display module may include a display panel 1, a color film layer, and a micro-lens layer 6; the color film layer is provided on the light-emitting side of the display panel 1, and the color film layer includes a plurality of light-filtering portions 4a; the micro-lens layer 6 includes a plurality of first converging lenses and a plurality of second converging lenses 62, a gap is provided between two adjacent first converging lenses, and an orthographic projection of a first converging lens on the display panel 1 is located within an orthographic projection of a light-filtering portions 4a on the display panel 1; a second converging lens 62 is provided in the gap 65 between two adjacent first converging lenses 61, and the second converging lens 62 is connected to the first converging lens 61.

According to the display module of the present disclosure, the light emitted from the light-filtering portion 4a may be converged by the first converging lens, so that the diffusion angle of the light emitted from the first converging lens is small, thus improving the display brightness within an effective viewing angle. When there is provided the gap 65 between two adjacent first converging lenses 61, the preparation process of the first converging lens 61 makes the shape of the first converging lens 61 more standard, thus ensuring the converging effect on the light and further improving the brightness. After a plurality of tests, the brightness improvement factor is about 1.4-1.6 times. The second converging lens 62 may converge the light emitted into the gap 65 between two adjacent first converging lenses 61, thus further improving the brightness of the display module.

In the example embodiment, referring to FIG. 1, the display panel 1 may include a substrate layer 11, and the substrate layer 11 may be a wafer, sapphire, or the like. A back plate 12 is provided on a side of the substrate layer 11, the back plate 12 includes a plurality of switch structures arranged in an array, and the switch structure may include a gate, a source, a drain, or the like. That is, a monocrystalline silicon integrated circuit is used as the back plate. A third planarization layer 13 is provided on a side of the back plate 12 away from the substrate layer 11. The third planarization layer 13 may provide a relatively flat base plane for the first electrode 14 and the light-emitting layer 16 formed subsequently, which is beneficial to the light-emitting effect of the light-emitting layer 16.

A first electrode 14 is provided on a side of the third planarization layer 13 away from the substrate layer 11, and the first electrode 14 is electrically connected to a source or a drain in the switch structure. The first electrode 14 is configured as a two-layer structure; one layer close to the third planarization layer 13 is a metal layer 141, and the material of the metal layer 141 may be titanium, silver, or the like; one layer away from the third planarization layer 13 is a transparent conductive layer 142, and the material of the transparent conductive layer 142 may be indium tin oxide (ITO), indium zinc oxide (IZO), or the like. The transparent conductive layer 142 completely covers the metal layer 141, so that the edge portion 143 of the transparent conductive layer 142 protrudes from the metal layer 141. The edge portion 143 of the transparent conductive layer 142 forms the edge portion 143 of the first electrode 14.

The width of the first converging lens 61 is greater than the maximum width of the first electrode 14. For example, in the case that the first electrode 14 is a regular hexagon, the maximum width of the first electrode 14 is the length of the diagonal line between two opposite corners of the regular hexagon. In the case that the first electrode 14 is rectangular, the maximum width of the first electrode 14 is the length of the diagonal line of the rectangle. A spacing space is provided between two adjacent first electrodes 14, and the width of the spacing space in a first direction is the distance between two adjacent first electrodes 14.

A pixel dielectric layer 15 is provided on a side of the first electrode 14 away from the substrate layer 11. A first via hole is provided on the pixel dielectric layer 15, and the first via hole exposes a portion of the first electrode 14. A light-emitting layer 16 is provided on a side of the pixel dielectric layer 15 away from the substrate layer 11 and in the first via hole, the light-emitting layer 16 is set as an entire layer and completely covers the pixel dielectric layer 15 and the first electrode 14, and the light-emitting layer 16 is connected to the first electrode 14. The orthographic projection of the first converging lens 61 on the substrate layer 11 is located within the orthographic projection of the light-emitting layer 16 on the substrate layer 11.

A second electrode 17 is provided on a side of the light-emitting layer 16 away from the substrate layer 11, and the second electrode 17 is also connected to the light-emitting layer 16. The second electrode 17 includes a flat portion 171 and a lower concave portion 172. A portion of the second electrode 17 opposite to the metal layer 141 of the first electrode 14 forms the flat portion 171 of the second electrode 17, since the height of such portion of the first electrode 14 is substantially unchanged. For the portion of the second electrode 17 opposite to the edge portion 143 of the first electrode 14, since the height of the edge portion 143 of the first electrode 14 gradually decreases, the second electrode 17 is gradually concaved to form the lower concave portion 172, and the lowest position of the lower concave portion 172 is formed at a position opposite to the spacing space between two adjacent first electrodes 14.

The first electrode 14, the light-emitting layer 16, and the second electrode 17 form a light-emitting structure. The light-emitting layer 16 in a via hole forms a light-emitting unit 18; that is, the light-emitting structure includes a light-emitting unit 18. The light-emitting unit 18 can be driven and controlled through a switch structure.

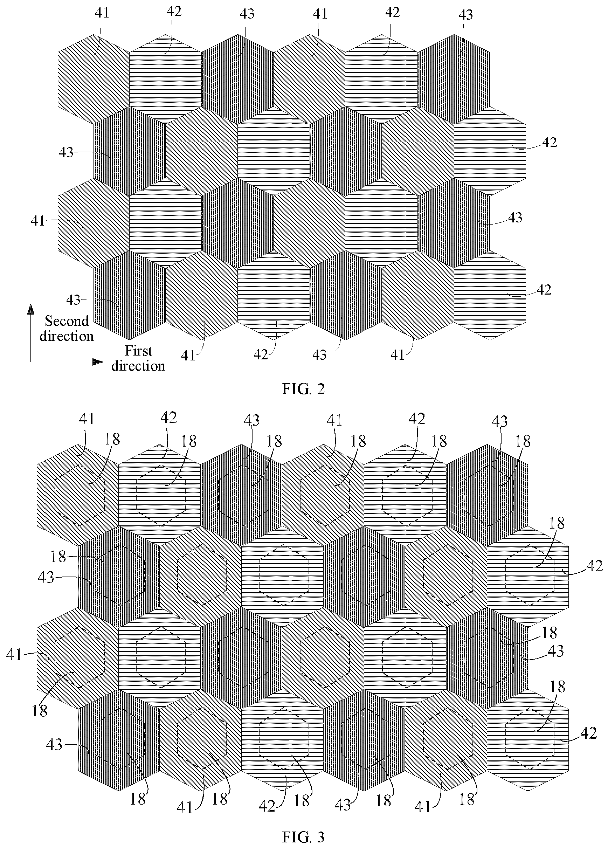

In the example embodiment, referring to FIG. 3, a cross section of the first via hole parallel to the substrate layer 11 may be configured as a regular hexagon, and a cross section of the light-emitting unit 18 parallel to the substrate layer 11 may be configured as a regular hexagon. Of course, in other example embodiments of the present disclosure, the cross section of the first via hole parallel to the substrate layer 11 may be configured as a rectangular, a circular, another regular polygon, etc. The cross section of the corresponding light-emitting unit 18 parallel to the substrate layer 11 may be configured as a rectangular, a circular, another regular polygon, etc.

The first electrode 14 may be an anode, and the second electrode 17 may be a cathode. The material of the first electrode 14 may be a conductive material including ITO (indium tin oxide), IZO (indium zinc oxide), or the like. The material of the second electrode 17 may be Mg, Ag, etc.

Continuing to refer to FIG. 1, a thin film encapsulation 2 (TFE) is provided on a side of the second electrode 17 away from the substrate layer 11. Since the material of the light-emitting layer 16 and the material of the cathode are relatively sensitive to water ($H_2O$) and oxygen ($O_2$), they are easy to oxidize; the thin film encapsulation 2 may achieve the effect of isolating water and oxygen to protect the display panel 1. The thin film encapsulation 2 may include an inorganic material layer and an organic material layer, and each film layer has good compactness. The number of layers of the inorganic material layer and the number of layers of the organic material layer as well as the relative position relationship may be configured according to needs.

In the example embodiment, the first planarization layer 3 may be provided on the light-emitting side of the display panel 1; that is, the first planarization layer 3 may be provided on the side of the thin film encapsulation 2 away from the substrate layer 11. A color film layer 4 is provided on a side of the first planarization layer 3 away from the display panel 1; that is, the first planarization layer 3 is provided between the display panel 1 and the color film layer 4. The first planarization layer 3 provides a relatively flat base surface for the color film layer 4, so that the formed color film layer 4 is flatter; and the first planarization layer 3 may increase the adhesion between the color film layer 4 and the display panel 1. Of course, in some other example embodiments of the present disclosure, the first planarization layer 3 may not be provided in the condition that the flat shape of the thin film encapsulation 2 is good.

In the example embodiment, referring to FIG. 1, the color film layer 4 may include a plurality of light-filtering portions 4a, and the plurality of light-filtering portions 4a may include a plurality of red light-filtering portions 41, a plurality of green light-filtering portions 42, and a plurality of blue light-filtering portions 43. An overlapping portion 44 is provided between two adjacent light-filtering portions 4a. For example, it may be that the edge portion of the red light-filtering portion 41 overlaps with the edge portion of the green light-filtering portion 42; it may also be that the edge portion of the green light-filtering portion 42 overlaps with the edge portion of the blue light-filtering portion 43; the portion where they overlap with each other forms the overlapping portion 44.

Referring to FIG. 2, the light-filtering portion 4a may also be configured as a regular hexagon, so that the plurality of light-filtering portions 4a may be densely distributed on the side of the first planarization layer 3 away from the display panel 1. Specifically, in a first direction, the red light-filtering portion 41, the green light-filtering portion 42, and the blue light-filtering portion 43 are sequentially arranged and circularly provided to form a row; a row of above light-filtering portions is sequentially arranged in a second direction, and two adjacent rows are provided in a staggered manner, so that the plurality of light-filtering portions can be densely provided. The first direction is perpendicular to the second direction. Of course, in other example embodiments of the present disclosure, the cross section of the light-filtering portion parallel to the substrate layer 11 may be configured as a rectangular, a circular, another regular polygon, etc.

Referring to FIG. 3, the light-filtering portion and the light-emitting unit 18 are in one-to-one correspondence; that is, one light-filtering portion corresponds to one light-emitting unit 18. The orthographic projection of the light-emitting unit 18 on the substrate layer 11 is located within the orthographic projection of the light-filtering portion on the substrate layer 11; that is, the area of the light-filtering portion is greater than the area of the light-emitting unit 18.

After being filtered through the color film layer 4, there may be monochromatic red light, blue light or green light passing through each light-filtering portion; that is, the light passing through the red light-filtering portion 41 is red light, and the light of other colors may be absorbed by the red light-filtering portion 41; the light passing through the blue light-filtering portion 43 is blue light, and the light of other colors may be absorbed by the blue light-filtering portion 43; and the light passing through the green light-filtering portion 42 is green light, and the light of other colors may be absorbed by the green light-filtering portion 42. Therefore, the brightness of the light emitted by the light-emitting unit 18 may be greatly reduced after passing through the color film layer 4. Specifically, the transmittance of the color film layer 4 is $\tau$, the aperture ratio (AR) of the light-filtering portion is $\alpha$, the brightness of the white light emitted by the light-emitting unit 18 is L, and then the brightness LCF that may be felt by human eyes after passing through the color film layer 4

is $\tau \times \alpha \times$ L. The transmittance of the color film layer 4 is about 18% -30%, and the aperture ratio is about 60% -70%. It can be seen through calculation that only about one quarter of the white light emitted by the light-emitting unit 18 is effectively utilized, resulting in a problem of lower brightness of the display module. However, in VR and AR fields, due to the factors such as low optical system efficiency or outdoor use, or the like, there are high requirements on the brightness of the Micro OLED micro-display.

Continuing to refer to FIG. 1, in the example embodiment, a second planarization layer 5 may be provided on a side of the color film layer 4 away from the display panel 1, and a micro-lens layer 6 may be provided on a side of the second planarization layer 5 away from the display panel 1; that is, the second planarization layer 5 may be provided between the color film layer 4 and the micro-lens layer 6. The second planarization layer 5 provides a relatively flat base surface for the micro-lens layer 6, so that the formed micro-lens layer 6 is more standard, further improving the light converging effect, and further improving the brightness of the display module. Of course, in some other example embodiments of the present disclosure, the second planarization layer 5 may not be provided.

Continuing to refer to FIG. 1, in some example embodiments of the present disclosure, the micro-lens layer 6 may include a plurality of first converging lenses 61. A gap 65 is provided between two adjacent first converging lenses 61; that is, there is no connection between two adjacent first converging lenses 61. The orthographic projection of a first converging lens 61 on the display panel 1 is within the orthographic projection of a light-filtering portion 4a on the display panel 1; that is, the first converging lens 61 is in one-to -one correspondence to the light-filtering portion 4a. The maximum area of the cross section of the first converging lens 61 parallel to the display panel 1 is smaller than or equal to the area of the light-filtering portion 4a. The orthographic projection of the light-emitting unit 18 on the substrate layer 11 is located within the orthographic projection of the first converging lens 61 on the substrate layer 11; that is, the maximum area of the cross section of the first converging lens 61 parallel to the display panel 1 is greater than or equal to the area of the light-emitting unit 18.

The light emitted from the light-filtering portion 4a may be converged by the first converging lens 61, so that the diffusion angle of the light emitted from the first converging lens 61 is small, thus improving the display brightness within an effective viewing angle. Moreover, in order to better converge to a large angle of light, the first converging lens 61 should be made as large as possible. For example, the width of the first converging lens 61 may be greater than the maximum width of the first electrode 14, so that the larger first converging lens 61 may converge to light within a larger angle range in the case of a certain height from the light source. However, the preparation process of the first converging lens 61 determines that there is needed a certain gap 65 between two adjacent first converging lenses 61 so as to ensure that the first converging lens 61 has a better shape (which is beneficial to converging light). That is, when there is provided a gap 65 between two adjacent first converging lenses 61, the preparation process of the first converging lens 61 can make the shape of the first converging lens 61 more standard, thus ensuring the convergence effect on light and further improving the brightness.

The first converging lens 61 may be provided as a hemispheroid. Of course, in other example embodiments of the present disclosure, the first converging lens 61 may also be configured as greater than a hemispheroid or smaller than a hemispheroid. The first converging lens 61 is configured to be a spherical segment structure to converge the lights in various directions emitted from the light-filtering portion 4a, thus further improving the display brightness within the effective viewing angle.

In addition, in a case that the light-emitting unit 18 is a rectangular and the rectangle includes a short side of shorter length and a long side of longer length, in order to adapt to the light-emitting unit 18, the first converging lens 61 may be configured as a structure of a semi-ellipsoid, smaller than a semi-ellipsoid, or greater than a semi-ellipsoid, which may also achieve that the lights in various directions emitted from the light-filtering portion 4a are converged, thus further improving the display brightness within the effective viewing angle. Of course, the first converging lens 61 may be configured as a structure such as a semi-cylindrical, greater than a semi-cylindrical, or smaller than a semi-cylindrical, etc.

In the example embodiment, there is a second converging lens 62 provided in the gap 65 between two adjacent first converging lenses 61.

Since there is provided a gap 65 between two adjacent first converging lenses 61, the light emitted into the gap 65 between two adjacent first converging lenses 61 cannot be converged; therefore, the improvement value of the brightness of the display module by the first converging lens 61 is not ideal enough. The light emitted into the gap 65 between two adjacent first converging lenses 61 may be converged by the second converging lens 62, thus further improving the brightness of the display module.

The width of the second converging lens 62 is less than 1/10 of the width of the first converging lens 61, and the height of the second converging lens 62 is less than 1/10 of the height of the first converging lens 61, such that the second converging lens 62 has a very small volume relative to the first converging lens 61. The convergence of light is mainly achieved by the first converging lens 61, and the second converging lens 62 mainly plays an auxiliary role. The second converging lens 62 is configured to be small enough to avoid the influence of the second converging lens 62 on the first converging lens 61. That is to avoid the influence of the main light-emitting region.

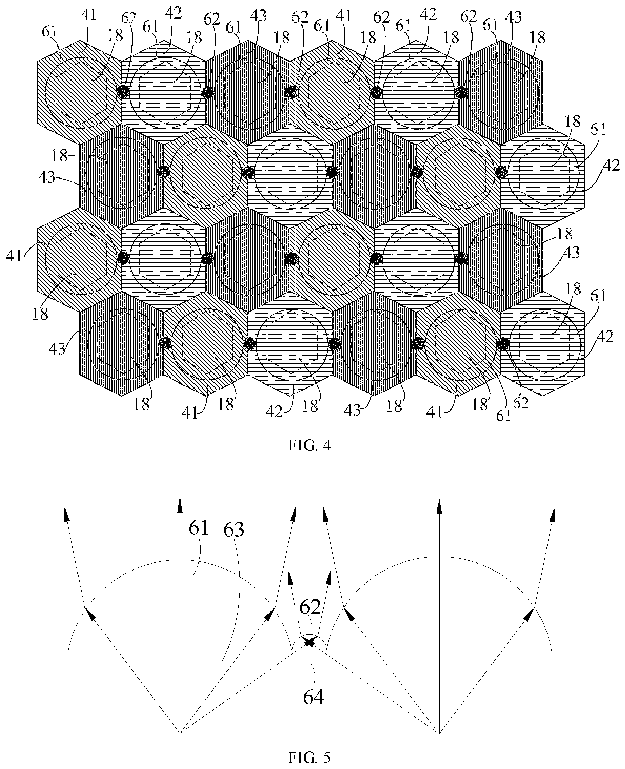

Moreover, referring to FIG. 1, the orthographic projection of the overlapping portion 44 between two adjacent light-filtering portions 4a on the display panel 1 overlaps with the orthographic projection of the second converging lens 62 on the display panel 1. Specifically, the red light-filtering portion and the green light-filtering portion are two adjacent light-filtering portions, and the orthographic projection of the overlapping portion 44 between the red light-filtering portion and the green light-filtering portion on the display panel 1 overlaps with the orthographic projection of the second converging lens 62 on the display panel 1. Referring to FIG. 5, it makes that the second converging lens 62 may refract the light of different colors emitted from the red light-filtering portion and the green light-filtering portion, and refract the light emitted from the red light-filtering portion toward the side of the red light-filtering portion, and refract the light emitted from the green light-filtering portion toward the side of the green light-filtering portion, thus reducing color crosstalk between the red light-filtering portion and the green light-filtering portion, and preventing color cast from being generated at a large viewing angle. Of course, there are the same beneficial effects on the light-filtering portions of other colors.

In addition, the highest point of the overlapping portion 44 away from the display panel 1 is generally located in the middle of the overlapping portion 44. On a cross section of overlapping portion 44 perpendicular to the display panel 1, the orthographic projection of highest point of the overlapping portion 44 away from the display panel 1 on the display panel 1 is located within the orthographic projection of the second converging lens 62 on the display panel 1, so that the second converging lens 62 is basically located in the middle of the overlapping portion 44. The refraction effects of the second converging lens 62 on the light emitted from two adjacent light-filtering portions 4a are basically the same, without one of the refraction angles being large and the other one of the refraction angles being small, so as to avoid a bad color cast.

Moreover, the overlapping portion 44 is opaque. For example, since the light emitted from the green light-filtering portion 42 is green light which is completely absorbed by the red light-filtering portion 41 after passing through the red light-filtering portion 41 that overlaps with the green light-filtering portion 41, so that no light is emitted from the red light-filtering portion 41, and no light is emitted from the overlapping portion 44, thus the overlapping portion 44 is opaque. Therefore, the light emitted along the light-filtering portion at the edge of the overlapping portion 44 forms an image of the overlapping portion 44, and the converging effect of the second converging lens 62 on the light makes the image of the overlapping portion 44 reduced, so that the area of the opaque region incident into human eyes is reduced, thus improving the aperture ratio of the display module.

In some other example embodiments of the present disclosure, the orthographic projection of the second converging lens 62 on the substrate layer 11 is at least partially located within the projection of the edge portion 143 of the first electrode 14 on the substrate layer 11. That is, the orthographic projection of the second converging lens 62 on the substrate layer 11 may be all located within the projection of the edge portion 143 of the first electrode 14 on the substrate layer 11, and the orthographic projection of the second converging lens 62 on the substrate layer 11 may also be partially located within the projection of the edge portion 143 of the first electrode 14 on the substrate layer 11, so that the second converging lens 62 is located at the edge of the light-emitting unit 18, and the second converging lens 62 is prevented from affecting the light path of the first converging lens 61, that is, avoiding the influence on the main light-emitting region.

In still some example embodiments of the present disclosure, the orthographic projection of the second converging lens 62 on the substrate layer 11 is located within the projection of the lower concave portion 172 on the substrate layer 11, so that the second converging lens 62 is located at the edge of the light-emitting unit 18, and the second converging lens 62 is prevented from affecting the light path of the first converging lens 61; that is, avoiding the influence on the main light-emitting region. In addition, it makes that the second converging lens 62 is basically located in the middle of two adjacent light-emitting units 18, and the refraction effects of the second converging lens 62 on the light emitted from two adjacent light-emitting units 18 are basically the same, thus avoiding a bad color cast.

In still other example embodiments of the present disclosure, the height of the second converging lens 62 is less than the interval between two adjacent first electrodes 14. It makes that the second converging lens 62 is small enough to prevent the second converging lens 62 from affecting the first converging lens 61; that is, avoiding the influence on the main light-emitting region.

The second converging lens 62 may be provided as a hemispheroid. Of course, in other example embodiments of the present disclosure, the second converging lens 62 may also be configured as greater than a hemispheroid or smaller than a hemispheroid. The second converging lens 62 is configured as a spherical segment structure to converge the lights in various directions emitted from the light-filtering portion 4a, thus further improving the display brightness within the effective viewing angle.

In addition, since the separating line between the two adjacent light-filtering portions 4a is generally a strip, in order to adapt to the separating line, the second converging lens 62 may be configured as a structure of a semi-ellipsoid, smaller than a semi-ellipsoid, or greater than a semi-ellipsoid, which may also achieve that the lights in various directions emitted from the light-filtering portion 4a are converged, thereby further improving the display brightness within the effective viewing angle. Furthermore, the color crosstalk between two adjacent light-filtering portions 4a can be reduced within a longer range, thus preventing color cast from being generated at a large viewing angle. Of course, the second converging lens 62 may be configured as a structure such as a semi-cylindrical, greater than a semi-cylindrical, or smaller than a semi-cylindrical, etc.

In some embodiments of the present disclosure, the micro-lens layer 6 may further include a first plate layer 63 and a second plate layer 64; the first plate layer 63 is provided between the color film layer 4 and the first converging lens 61; the second plate layer 64 is provided between the color film layer 4 and the second converging lens 62; the second plate layer 64 is connected to the first plate layer 63; and the first plate layer 63 and the second plate layer 64 as well as the micro-lens layer 6 may be formed through the same patterning process. By providing the first flat plate layer 63 and the second flat plate layer 64, it may avoid damage to the first planarization layer 3 when the first converging lens 61 and the second converging lens 62 are formed; and the process operation is facilitated, the process difficulty is reduced, and the efficiency is improved.

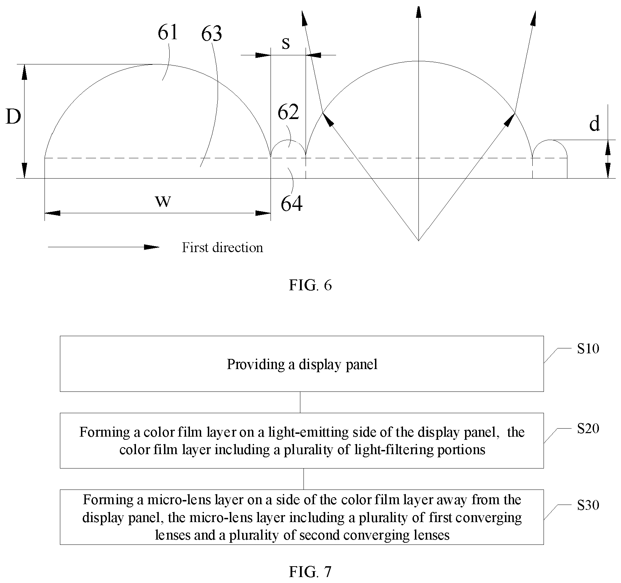

Referring to FIG. 1 and FIG. 6, since the second converging lens 62 is provided between two adjacent first converging lenses 61, and the orthographic projection of the separating line between two adjacent filtering portions 4a on the display panel 1 is at least partially located within the orthographic projection of the second converging lens 62 on the display panel 1, therefore, $w + s = P$. In the formula, $P$ is the width of the light-filtering portion 4a in the first direction, which has been determined during design and is a known number. $s$ is the width of the gap 65 in the first direction, which is also the width of the second converging lens 62 in the first direction and is determined by the limit of the resolution of the first converging lens 61; that is, s is determined by the size of the aperture of the photolithography mask (the material of the micro-lens material layer is a positive photoresist, and the photosensitive portion is removed during development) and is a known number. $w$ is the width of the first converging lens 61 in the first direction, which may be calculated according to the two known numbers.

The light path between the light-emitting surface of the display panel 1 and the surface of the micro-lens layer 6 close to the display panel 1 is $L = \Sigma \, Lini$. In the formula, $Li$ is the thickness of each film layer between the light-emitting surface of the display panel 1 and the micro-lens layer, and $ni$ is the refractive index of each film layer between the light-emitting surface of the display panel 1 and the micro-lens layer.

Since the first converging lens 61 is a hemispheroid, the first converging lens 61 and the second converging lens 62 satisfy a following relationship:

$$D\text{-}d = (P\text{-}s)/2.$$

In the formula, $D$ is the sum of the height of the first converging lens 61 and the height of the first flat plate layer 63, and $d$ is the sum of the height of the second converging lens 62 and the height of the second flat plate layer 64.

Moreover, the object focal length $f$ of the first converging lens 61 of the hemispheroid is approximately as follows:

$$1/f = 2 \times (n\text{-}1)/(P\text{-}s).$$

In the formula, $n$ is the refractive index of the first converging lens 61.

The light-emitting surface of the light-emitting layer 16 is provided on the object focal plane, and $L = f$. Therefore, it can be obtained that the thickness and the refractive index of each film layer between the light-emitting surface of the display panel 1 and the micro-lens layer satisfy the following relationship:

$$L = \Sigma \, Lini \approx (P\text{-}s)/[2 \times (n\text{-}1)].$$

In the formula, $L$ is the light path between the light-emitting surface of the display panel 1 and the surface of the flat plate layer close to the display panel 1. The width $P$ of the light-filtering portion 4a in the first direction, the width s of the gap 65 in the first direction, and the refractive index $n$ of the first converging lens 61 are all known numbers. Therefore, the thickness and the refractive index of each film layer between the light-emitting surface of the display panel 1 and the micro-lens layer can be adjusted according to the above formula, so as to satisfy the requirement of the above formula.

In the example embodiment, the display module may further include an adhesive layer 7. The adhesive layer 7 is provided on a side of the micro-lens layer 6 away from the display panel 1, and the material of the adhesive layer 7 may be an optically clear adhesive (OCA).

In the example embodiment, the display module may further include a cover plate 8. The cover plate 8 is provided on a side of the adhesive layer 7 away from the display panel 1; that is, the cover plate 8 is bonded to the micro-lens layer 6 through the adhesive layer 7. The cover plate 8 plays a role of protecting the display module.

Based on the same inventive concept, according to example embodiments of the present disclosure, there is provided a method for preparing a display module. With reference to the flowchart of the method for preparing the display module of the present disclosure as shown in FIG. 7, the method for preparing the display module may include the following steps.

In step S10, a display panel 1 is provided.

In step S20, a color film layer 4 is formed on a light-emitting side of the display panel 1, and the color film layer 4 includes a plurality of light-filtering portions 4a.

In step S30, a micro-lens layer 6 is formed on a side of the color film layer 4 away from the display panel 1, and the micro-lens layer 6 includes a plurality of first converging lenses 61 and a plurality of second converging lenses 62.

Among them, there is provided a gap 65 between two adjacent first converging lenses 61, and an orthographic projection of a first converging lens 61 on the display panel 1 is located within an orthographic projection of a light-filtering portion 4a on the display panel 1. A second converging lens 62 is provided in the gap 65 between two adjacent first converging lenses 61, and the second converging lens 62 is connected to the first converging lens 61.

Various steps of the method for preparing the display module are described in detail below.

The method for preparing the display panel 1 adopts the current existing preparation method, and therefore, details are not described here again.

The first planarization layer 3 is formed on the light-emitting side of the display panel 1 through the method of deposition, coating, or the like

Firstly, a red light-filtering material layer is formed on the side of the first planarization layer 3 away from the display panel 1 through the method of deposition, coating, or the like. Then, the red light-filtering material layer is subjected to photolithography to form the red light-filtering portion 41.

Next, a green light-filtering material layer is formed on the side of the first planarization layer 3 away from the display panel 1 through the method of deposition, coating, or the like. Then, the green light-filtering material layer is subjected to photolithography to form the green light-filtering portion 42.

Furthermore, a blue light-filtering material layer is formed on the side of the first planarization layer 3 away from the display panel 1 through the method of deposition, coating, or the like. Then, the blue light-filtering material layer is subjected to photolithography to form the blue light-filtering portion 43.

It should be noted that the order to form the red light-filtering portion 41, the green light-filtering portion 42, and the blue light-filtering portion 43 may be changed as needed.

Since the red light-filtering material, the green light-filtering material and the blue light-filtering material are all negative photoresist, there will be a certain expansion during development, so that there is a certain overlap between the light-filtering portions 4a of different colors. The height of the overlapping portion is higher than the height of the nonoverlapping portion, so that the surface of the color film layer 4 is uneven.

The second planarization layer 5 is formed on the side of the color film layer 4 away from the display panel 1 through the method of deposition, coating, or the like. The second planarization layer 5 may provide a relatively flat base surface for the subsequently formed micro-lens layer.

The micro-lens material layer is formed on the side of the second planarization layer 5 away from the display panel 1 through the method of deposition, coating, or the like. The micro-lens material layer is made of an organic resin, and the thickness of the micro-lens material layer is $D1$ ($D$ is greater than $D1$, and the difference between $D$ and $D1$ is about 0.1 $\mu$m to 0.2 $\mu$m). Then, the micro-lens material layer is subjected to photolithography to form a preset pattern layer. However, the exposure time or the light intensity during exposure is reduced, so that the micro-lens material layer retains a layer with a thickness of $d1$ ($d$ is greater than $d1$, and a difference between $d$ and $d1$ is about 0.05 $\mu$m to 0.15 $\mu$m); that is, the preset pattern layer includes a flat plate layer and a protruding portion, and the protruding portion is formed on the side of the flat plate layer away from the display panel 1. Secondly, baking is performed; the baking time is greater than or equal to 50 minutes and less than or equal to 70 minutes; for example, the baking time may be 60 minutes; the baking temperature is greater than or equal to 100° C and less than or equal to 130° C; for example, the baking temperature may be 115° C. Finally, natural cooling is performed. During baking, the micro-lens material layer may expand to a certain extent, so that the protruding portion forms the first converging lens 61, and the gap between the two first converging lenses 61 is small. The flat plate layer in the gap is not prone to diffusing during baking expansion so as to form the second converging lens 62, and the flat plate layers at other positions are prone to diffusing during baking expansion so as not to form the second converging lens 62.

It should be noted that, although the various steps of the method for preparing the display module in the present disclosure are described in a specific order in the drawings, this does not require or imply that these steps must be performed in this specific order, or that all the illustrated steps must be performed to achieve the desired results. Additionally or alternatively, some steps may be omitted, a plurality of steps may be combined into one step to be performed, and/or one step may be decomposed into a plurality of steps for execution, etc.

Based on the same inventive concept, according to example embodiments of the present disclosure, there is provided a display device. The display device may include any of the above-mentioned display module. The specific structure of the display module has been described in detail above, and therefore, details are not described here again.

The specific type of the display device is not particularly limited, which may be a common display device type in the art; specifically, for example, it may be a mobile device such as a mobile phone, a wearable device such as a watch, an AR (augmented reality)/VR (virtual reality) device, etc. Those skilled in the art may correspondingly select according to the specific use of the display device, which will not be repeated here. In particular, AR/VR technology tends to mature, getting more and more attention to the consumer market and manufacturing industry, and the market share of AR/VR in 2025 years is expected to exceed 1,000 billion dollars.

It should be noted that, in addition to the display panel 1, the display device further includes other necessary components and compositions, specifically such as a housing, a circuit board, a power line, or the like, by taking the display as an example. Those skilled in the art may correspondingly supplement according to the specific use requirements of the display device, and details are not described here again.

Compared with the related art, the beneficial effects of the display device provided by the embodiments of the present disclosure are the same as the beneficial effects of the display module provided by the above example embodiments, and details are not described here.

## Claims

1. A display module, comprising:

    a display panel (1);
    a color film layer (4), provided on a light-emitting side of the display panel (1), wherein the color film layer (4) comprises a plurality of light-filtering portions (4a); and
    a micro-lens layer (6), provided on a side of the color film layer (4) away from the display panel (1); **characterized in that**
    the micro-lens layer (6) comprises a plurality of first converging lenses (61) and a plurality of second converging lenses (62), a gap (65) is provided between two adjacent first converging lenses (61), and an orthographic projection of a first converging lens (61) on the display panel (1) is located within an orthographic projection of a light-filtering portion (4a) on the display panel (1); a second converging lens (62) is provided in the gap (65) between two adjacent first converging lenses (61), and the second converging lens (62) is connected to the first converging lens (61).

2. The display module according to claim 1, wherein an overlapping portion (44) is provided between two adjacent light-filtering portions (4a), the overlapping portion (44) is formed by edge portions of the two adjacent light-filtering portions (4a) overlapping with each other, and an orthographic projection of the overlapping portion (44) on the display panel (1) overlaps with an orthographic projection of the second converging lens (62) on the display panel (1).

3. The display module according to claim 2, wherein, on a cross section of the overlapping portion (44) perpendicular to the display panel (1), an orthographic projection of a highest point of the overlapping portion (44) away from the display panel (1) on the display panel (1) is located within the orthographic projection of the second converging lens (62) on the display panel (1).

4. The display module according to claim 1, wherein a width of the second converging lens (62) is less than 1/10 of a width of the first converging lens (61), and a height of the second converging lens (62) is less than 1/10 of a height of the first converging lens (61); or the first converging lens (61) is configured as a spherical segment structure, and the second converging lens (62) is configured as a spherical segment structure.

5. The display module according to any one of claims 1 to 4, wherein the display panel (1) comprises:

    a substrate layer (11);
    a first electrode (14), provided on a side of the substrate layer (11) close to the color film layer (4);
    a light-emitting layer (16), provided on a side of the first electrode (14) away from the substrate layer (11); and
    a second electrode (17), provided on a side of the light-emitting layer (16) away from the substrate layer (11);
    wherein an orthographic projection of the second converging lens (62) on the substrate layer (11) is at least partially located within a projection of an edge portion of the first electrode (14) on the substrate layer (11).

6. The display module according to claim 5, wherein the second electrode (17) comprises a flat portion (171) and a lower concave portion (172), and the orthographic projection of the second converging lens (62) on the substrate layer (11) is located within a projection of the lower concave portion (172) on the substrate layer (11); or

    a width of the first converging lens (61) is greater than a maximum width of the first electrode (14); or
    a height of the second converging lens (62) is less than an interval between two adjacent first electrodes (14); or
    an orthographic projection of the first converging lens (61) on the substrate layer (11) is located within an orthographic projection of the light-emitting layer (16) on the substrate layer (11).

7. The display module according to any one of claims 1 to 6, wherein the micro-lens layer (6) further comprises:

    a first flat plate layer (63), provided between the color film layer (4) and the first converging lens (61); and
a second flat plate layer (64), provided between the color film layer (4) and the second converging lens (62), wherein the second flat plate layer (64) is integrally connected to the first flat plate layer (63).

8. The display module according to claim 7, wherein the first converging lens (61) and the second converging lens (62) satisfy a following relationship:

$$D\text{-}d = (P\text{-}s)/2,$$

wherein $P$ is a width of the light-filtering portion (4a) in a first direction, s is a width of the gap (65) in the first direction, $D$ is a sum of a height of the first converging lens (61) and a height of the first flat plate layer (63), and $d$ is a sum of a height of the second converging lens (62) and a height of the second flat plate layer (64).

9. The display module according to claim 8, wherein a thickness and a refractive index of each film layer between a light-emitting surface of the display panel (1) and the micro-lens layer (6) satisfy a following relationship:

$$L = \Sigma L_i n_i \approx (P\text{-}s)/[2 \times (n-1)],$$

wherein $L$ is a light path between the light-emitting surface of the display panel (1) and a surface of the micro-lens layer (6) close to the display panel (1), $n$ is a refractive index of the first converging lens (61), $L_i$ is the thickness of each film layer between the light-emitting surface of the display panel (1) and the micro-lens layer (6), and $n_i$ is the refractive index of each film layer between the light-emitting surface of the display panel (1) and the micro-lens layer (6).

10. The display module according to any one of claims 1 to 9, further comprising:

a first planarization layer (3), provided between the display panel (1) and the color film layer (4); and
a second planarization layer (5), provided between the color film layer (4) and the micro-lens layer (6).

11. A method for preparing a display module, comprising:

providing a display panel (1);
forming a color film layer (4) on a light-emitting side of the display panel (1), wherein the color film layer (4) comprises a plurality of light-filtering portions (4a); and
forming a micro-lens layer (6) on a side of the color film layer (4) away from the display panel (1), **characterized in that**
the micro-lens layer (6) comprises a plurality of first converging lenses (61) and a plurality of second converging lenses (62);
wherein a gap (65) is provided between two adjacent first converging lenses (61), an orthographic projection of a first converging lens (61) on the display panel (1) is located within an orthographic projection of a light-filtering portion (4a) on the display panel (1), a second converging lens (62) is formed in the gap (65) between two adjacent first converging lenses (61), and the second converging lens (62) is connected to the first converging lens (61).

12. The method for preparing the display module according to claim 11, wherein a first flat plate layer (63) and a second flat plate layer (64) are formed while forming the first converging lens (61) and the second converging lens (62), the first flat plate layer (63) is formed between the color film layer (4) and the first converging lens (61), the second flat plate layer (64) is formed between the color film layer (4) and the second converging lens (62), and the second flat plate layer (64) is connected to the first flat plate layer (63).

13. The method for preparing the display module according to claim 12, wherein forming the micro-lens layer (6) on the side of the color film layer (4) away from the display panel (1) comprises:
forming a micro-lens material layer on the side of the color film layer (4) away from the display panel (1), then forming a preset pattern layer by performing patterned processing on the micro-lens material layer, and then forming the first converging lens (61), the second converging lens (62), the first flat plate layer (63) and the second flat plate layer (64) by baking the preset pattern layer.

14. The method for preparing the display module according to claim 13, wherein a baking temperature is greater than or equal to 100° C and less than or equal to 130° C, and a baking time is greater than or equal to 50 minutes and less than or equal to 70 minutes.

15. A display device, comprising the display module according to any one of claims 1 to 10.

**Patentansprüche**

1. Anzeigemodul, umfassend:

eine Anzeigetafel (1);

eine Farbfilmschicht (4), die auf einer lichtemittierenden Seite der Anzeigetafel (1) vorgesehen ist, wobei die Farbfilmschicht (4) eine Vielzahl lichtfilternder Abschnitte (4a) umfasst; und eine Mikrolinsenschicht (6), die auf einer Seite der Farbfilmschicht (4) vorgesehen ist, die von der Anzeigetafel (1) entfernt ist; **dadurch gekennzeichnet, dass**

die Mikrolinsenschicht (6) eine Vielzahl von ersten Konvergenzlinsen (61)

und eine Vielzahl von zweiten Sammellinsen (62) umfasst, zwischen zwei benachbarten ersten Sammellinsen (61) ein Spalt (65) vorgesehen ist und sich eine orthogonale Projektion einer ersten Sammellinse (61) auf der Anzeigetafel (1) an dem Ort einer orthografischen Projektion eines Lichtfilterabschnitts (4a) auf der Anzeigetafel (1) befindet; eine zweite Sammellinse (62) in dem Spalt (65) zwischen zwei benachbarten ersten Sammellinsen (61) vorgesehen ist, und die zweite Sammellinse (62) mit der ersten Sammellinse (61) verbunden ist.

2. Anzeigemodul nach Anspruch 1, wobei ein überlappender Abschnitt (44) zwischen zwei benachbarten Lichtfilterabschnitten (4a) vorgesehen ist, der überlappende Abschnitt (44) durch Kantenabschnitte der beiden benachbarten lichtfilternden Abschnitte (4a) gebildet wird, die sich gegenseitig überlappen, und eine orthogonale Projektion des überlappenden Abschnitts (44) auf der Anzeigetafel (1) sich mit einer orthogonalen Projektion der zweiten Konvergenzlinse (62) auf der Anzeigetafel (1) überlappt.

3. Anzeigemodul nach Anspruch 2, wobei sich auf einem Querschnitt des überlappenden Abschnitts (44) senkrecht zur Anzeigetafel (1) eine orthogonale Projektion eines höchsten Punkts des überlappenden Abschnitts (44) entfernt von der Anzeigetafel (1) auf der Anzeigetafel (1) innerhalb der orthogonalen Projektion der zweiten Konvergenzlinse (62) auf der Anzeigetafel (1) befindet.

4. Anzeigemodul nach Anspruch 1, wobei die Breite der zweiten Sammellinse (62) weniger als 1/10 der Breite der ersten Sammellinse (61) beträgt und die Höhe der zweiten Sammellinse (62) weniger als 1/10 der Höhe der ersten Sammellinse (61) beträgt; oder die erste Sammellinse (61) als sphärische Segmentstruktur ausgebildet ist und die zweite Sammellinse (62) als sphärische Segmentstruktur ausgebildet ist.

5. Anzeigemodul nach einem der Ansprüche 1 bis 4, wobei die Anzeigetafel (1) Folgendes umfasst:

eine Substratschicht (11); eine erste Elektrode (14), die auf einer Seite der Substratschicht (11) in der Nähe der Farbfilmschicht (4) vorgesehen ist; eine lichtemittierende Schicht (16), die auf einer Seite der ersten Elektrode (14) vorgesehen ist, die von der Substratschicht (11) entfernt ist; und eine zweite Elektrode (17), die auf einer Seite der lichtemittierenden Schicht (16) vorgesehen ist, die von der Substratschicht (11) entfernt ist; wobei eine orthogonale Projektion der zweiten Sammellinse (62) auf die Substratschicht (11) sich mindestens teilweise auf einem Ort innerhalb einer Projektion eines Randabschnitts der ersten Elektrode (14) auf die Substratschicht (11) befindet.

6. Anzeigemodul nach Anspruch 5, wobei die zweite Elektrode (17) einen flachen Abschnitt (171) und einen unteren konkaven Abschnitt (172) umfasst und die orthogonale Projektion der zweiten Konvergenzlinse (62) sich auf der Substratschicht (11) an dem Ort einer Projektion des unteren konkaven Abschnitts (172) auf der Substratschicht (11) befindet; oder

die Breite der ersten Konvergenzlinse (61) größer ist als die maximale Breite der ersten Elektrode (14); oder die Höhe der zweiten Sammellinse (62) geringer ist als der Abstand zwischen zwei benachbarten ersten Elektroden (14); oder sich ein Ort der orthogonalen Projektion der ersten Konvergenzlinse (61) auf der Substratschicht (11) innerhalb eines Ortes der orthogonalen Projektion der lichtemittierenden Schicht (16) auf der Substratschicht (11) befindet.

7. Anzeigemodul nach einem der Ansprüche 1 bis 6, wobei die Mikrolinsenschicht (6) ferner Folgendes umfasst:

eine erste flache Plattenschicht (63), die zwischen der Farbfilmschicht (4) und der ersten Sammellinse (61) vorgesehen ist; und eine zweite flache Plattenschicht (64), die zwischen der Farbfilmschicht (4) und der zweiten Sammellinse (62) vorgesehen ist, wobei die zweite flache Plattenschicht (64) integral mit der ersten flachen Plattenschicht (63) verbunden ist.

8. Anzeigemodul nach Anspruch 7, wobei die erste Sammellinse (61) und die zweite Sammellinse (62) die folgende Beziehung erfüllen:

$$D-d = (P-s)/2,$$

wobei P die Breite des lichtfilternden Abschnitts (4a) in einer ersten Richtung ist, s die Breite des Spalts (65) in der ersten Richtung ist, D die Summe aus der Höhe der ersten Sammellinse (61) und der Höhe der ersten flachen Plattenschicht (63) ist und d die Summe aus der Höhe der zweiten Sammellinse (62) und der Höhe der zweiten flachen Plattenschicht (64) ist.

9. Anzeigemodul nach Anspruch 8, wobei die Dicke und der Brechungsindex jeder Schicht zwischen der lichtemittierenden Oberfläche der Anzeigetafel (1) und der Mikrolinsenschicht (6) die folgende Beziehung erfüllen:

$$L = \sum L_i n_i \approx (P-s)/[2 \times (n-1)],$$

wobei $L$ ein Lichtweg zwischen der lichtemittierenden Oberfläche der Anzeigetafel (1) und einer Oberfläche der Mikrolinsenschicht (6) in der Nähe der Anzeigetafel (1) ist, $n$ ein Brechungsindex der ersten Sammellinse (61) ist, $L_i$ die Dicke jeder Schicht zwischen der lichtemittierenden Oberfläche der Anzeigetafel (1) und der Mikrolinsenschicht (6) ist und $n_i$ der Brechungsindex jeder Schicht zwischen der lichtemittierenden Oberfläche der Anzeigetafel (1) und der Mikrolinsenschicht (6) ist.

10. Anzeigemodul nach einem der Ansprüche 1 bis 9, ferner umfassend:

   eine erste Planarisierungsschicht (3), die zwischen der Anzeigetafel (1) und der Farbfilmschicht (4) vorgesehen ist; und
   eine zweite Planarisierungsschicht (5), die zwischen der Farbfilmschicht (4) und der Mikrolinsenschicht (6) vorgesehen ist.

11. Verfahren zum Vorbereiten eines Anzeigemoduls, umfassend:

   Bereitstellen einer Anzeigetafel (1);
   Bilden einer Farbfilmschicht (4) auf einer lichtemittierenden Seite der Anzeigetafel (1), wobei die Farbfilmschicht (4) eine Vielzahl Lichtfilterabschnitte (4a) umfasst; und
   Bilden einer Mikrolinsenschicht (6) auf einer Seite der Farbfilmschicht (4), die von der Anzeigetafel (1) entfernt ist, **dadurch gekennzeichnet, dass** die Mikrolinsenschicht (6) eine Vielzahl von ersten Sammellinsen (61) und eine Vielzahl von zweiten Sammellinsen (62) umfasst;
   wobei zwischen zwei benachbarten ersten Sammellinsen (61) ein Spalt (65) vorgesehen ist und sich eine orthogonale Projektion einer ersten Sammellinse (61) auf der Anzeigetafel (1) an dem Ort einer orthografischen Projektion eines Lichtfilterabschnitts (4a) auf der Anzeigetafel (1) befindet; eine zweite Sammellinse (62) in dem Spalt (65) zwischen zwei benachbarten ersten Sammellinsen (61) gebildet ist, und die zweite Sammellinse (62) mit der ersten Sammellinse (61) verbunden ist.

12. Verfahren zum Vorbereiten des Anzeigemoduls nach Anspruch 11, wobei eine erste flache Plattenschicht (63) und eine zweite flache Plattenschicht (64) gebildet werden, während die erste Sammellinse (61) und die zweite Sammellinse (62) gebildet werden, wobei die erste flache Plattenschicht (63) zwischen der Farbfilmschicht (4) und der ersten Sammellinse (61) gebildet wird, die zweite flache Plattenschicht (64) zwischen der Farbfilmschicht (4) und der zweiten Sammellinse (62) gebildet wird und die zweite flache Plattenschicht (64) mit der ersten flachen Plattenschicht (63) verbunden ist.

13. Verfahren zum Vorbereiten des Anzeigemoduls nach Anspruch 12, wobei das Bilden der Mikrolinsenschicht (6) auf der von der Anzeigetafel (1) abgewandten Seite der Farbfilmschicht (4) Folgendes umfasst:
   Bilden einer Mikrolinsenmaterialschicht auf der von der Anzeigetafel (1) abgewandten Seite der Farbfilmschicht (4), anschließendes Bilden einer voreingestellten Mustersicht durch Ausführen einer Musterbearbeitung auf der Mikrolinsenmaterialschicht und anschließendes Bilden der ersten Sammellinse (61), die zweite Sammellinse (62), die erste flache Plattenschicht (63) und die zweite flache Plattenschicht (64) durch Aushärten der vordefinierten Mustersicht.

14. Verfahren zum Vorbereiten des Anzeigemoduls nach Anspruch 13, wobei die Backtemperatur größer oder gleich 100 °C und kleiner oder gleich 130 °C ist und die Backzeit größer oder gleich 50 Minuten und kleiner oder gleich 70 Minuten ist.

15. Anzeigevorrichtung, umfassend das Anzeigemodul nach einem der Ansprüche 1 bis 10.

**Revendications**

1. Module d'affichage, comprenant :

   un panneau d'affichage (1) ;
   une couche de film coloré (4), prévue sur un côté émetteur de lumière du panneau d'affichage (1), dans lequel la couche de film coloré (4) comprend une pluralité de parties de filtrage de lumière (4a) ; et
   une couche de microlentilles (6), prévue sur un côté de la couche de film coloré (4) éloignée du panneau d'affichage (1) ; **caractérisée en ce que** la couche de microlentilles (6) comprend une pluralité de premières lentilles convergentes (61) et une pluralité de secondes lentilles convergentes (62), un espace (65) est prévu entre deux premières lentilles convergentes adjacentes (61), et une projection orthographique d'une première lentille convergente (61) sur le panneau d'affichage (1) est située dans une projection orthographique d'une partie de filtrage de lumière (4a) sur le panneau d'affichage (1) ; une seconde lentille convergente (62) est prévue dans l'espace (65) entre deux premières lentilles convergentes adjacentes (61), et la seconde lentille convergente (62) est connectée à la première lentille convergente (61).

2. Module d'affichage selon la revendication 1, dans lequel une partie de chevauchement (44) est prévue entre deux parties de filtrage de lumière adjacentes (4a), la partie de chevauchement (44) est formée par les parties de bord des deux parties de filtrage de lumière adjacentes (4a) se chevauchant l'une avec l'autre, et une projection orthographique de la partie de chevauchement (44) sur le panneau d'affichage (1) chevauche une projection orthographique de la seconde lentille convergente (62) sur le panneau d'affichage (1).

3. Module d'affichage selon la revendication 2, dans lequel, sur une section transversale de la partie chevauchante (44) perpendiculaire au panneau d'affichage (1), une projection orthographique d'un point le plus haut de la partie chevauchante (44) éloignée du panneau d'affichage (1) sur le panneau d'affichage (1) est située dans la projection orthographique de la seconde lentille convergente (62) sur le panneau d'affichage (1).

4. Module d'affichage selon la revendication 1, dans lequel la largeur de la seconde lentille convergente (62) est inférieure à 1/10 de la largeur de la première lentille convergente (61), et la hauteur de la seconde lentille convergente (62) est inférieure à 1/10 de la hauteur de la première lentille convergente (61) ; ou la première lentille convergente (61) est configurée comme une structure de segment sphérique, et la seconde lentille convergente (62) est configurée comme une structure de segment sphérique.

5. Module d'affichage selon l'une quelconque des revendications 1 à 4, dans lequel le panneau d'affichage (1) comprend :

une couche de substrat (11) ; une première électrode (14), prévue sur un côté de la couche de substrat (11) proche de la couche de film de coloré (4) ; une couche émettrice de lumière (16), prévue sur un côté de la première électrode (14) éloigné de la couche de substrat (11) ; et une seconde électrode (17), prévue sur un côté de la couche émettrice de lumière (16) éloigné de la couche de substrat (11) ; dans lequel une projection orthographique de la seconde lentille convergente (62) sur la couche de substrat (11) est au moins partiellement située dans une projection d'une partie de bord de la première électrode (14) sur la couche de substrat (11).

6. Module d'affichage selon la revendication 5, dans lequel la seconde électrode (17) comprend une partie plane (171) et une partie concave inférieure (172), et la projection orthographique de la seconde lentille convergente (62) sur la couche de substrat (11) est située dans une projection de la partie concave inférieure (172) sur la couche de substrat (11) ; ou

la largeur de la première lentille convergente (61) est supérieure à la largeur maximale de la première électrode (14) ; ou la hauteur de la seconde lentille convergente (62) est inférieure à l'intervalle entre deux premières électrodes adjacentes (14) ; ou une projection orthographique de la première lentille convergente (61) sur la couche de substrat (11) est située dans une projection orthographique de la couche émettrice de lumière (16) sur la couche de substrat (11).

7. Module d'affichage selon l'une quelconque des revendications 1 à 6, dans lequel la couche de microlentilles (6) comprend également :

une première couche de plaque plane (63), prévue entre la couche de film coloré (4) et la première lentille convergente (61) ; et une seconde couche de plaque plane (64), prévue entre la couche de film coloré (4) et la seconde lentille convergente (62), dans lequel la seconde couche de plaque plane (64) est connectée intégralement à la première couche de plaque plane (63).

8. Module d'affichage selon la revendication 7, dans lequel la première lentille convergente (61) et la seconde lentille convergente (62) satisfont à la relation suivante :

$$D-d = (P-s)/2,$$

dans lequel $P$ est une largeur de la partie de filtrage de lumière (4a) dans une première direction, s est une largeur de l'espace (65) dans la première direction, D est une somme d'une hauteur de la première lentille convergente (61) et d'une hauteur de la première couche de plaque plane (63), et *d* est une somme d'une hauteur de la seconde lentille convergente (62) et d'une hauteur de la seconde couche de plaque plane (64).

9. Module d'affichage selon la revendication 8, dans lequel l'épaisseur et l'indice de réfraction de chaque couche de film entre une surface émettrice de lumière du panneau d'affichage (1) et la couche de microlentilles (6) satisfont à la relation suivante :

$$ L = \sum L_i n_i \approx (P - s)/[2 \times (n - 1)], $$

Dans lequel *L* est un chemin lumineux entre la surface émettrice de lumière du panneau d'affichage (1) et une surface de la couche de microlentilles (6) proche du panneau d'affichage (1), *n* est un indice de réfraction de la première lentille convergente (61), $L_i$ est l'épaisseur de chaque couche de film entre la surface émettrice de lumière du panneau d'affichage (1) et la couche de microlentilles (6), et $n_i$ est l'indice de réfraction de chaque couche de film entre la surface émettrice de lumière du panneau d'affichage (1) et la couche de microlentilles (6).

10. Module d'affichage selon l'une quelconque des revendications 1 à 9, comprenant également :

une première couche de planarisation (3), prévue entre le panneau d'affichage (1) et la couche de film coloré (4) ; et
une seconde couche de planarisation (5), prévue entre la couche de film coloré (4) et la couche de microlentilles (6).

11. Procédé de préparation d'un module d'affichage, comprenant :

la fourniture d'un panneau d'affichage (1) ;
la formation d'une couche de film coloré (4) sur un côté émetteur de lumière du panneau d'affichage (1), dans lequel la couche de film coloré (4) comprend une pluralité de parties de filtrage de lumière (4a) ; et la formation d'une couche de microlentilles (6) sur un côté de la couche de film coloré (4) éloigné du panneau d'affichage (1), **caractérisé en ce que**
la couche de microlentilles (6) comprend une pluralité de premières lentilles convergentes (61) et une pluralité de secondes lentilles convergentes (62) ;
dans lequel un espace (65) est prévu entre deux premières lentilles convergentes adjacentes (61), une projection orthographique d'une première lentille convergente (61) sur le panneau d'affichage (1) est située dans une projection orthographique d'une partie de filtrage de lumière (4a) sur le panneau d'affichage (1), une seconde lentille convergente (62) est formée dans l'espace (65) entre deux premières lentilles convergentes adjacentes (61), et la seconde lentille convergente (62) est connectée à la première lentille convergente (61).

12. Procédé de préparation du module d'affichage selon la revendication 11, dans lequel une première couche de plaque plane (63) et une seconde couche de plaque plane (64) sont formées lors de la formation de la première lentille convergente (61) et de la seconde lentille convergente (62), la première couche de plaque plane (63) est formée entre la couche de film coloré (4) et la première lentille convergente (61), la seconde couche de plaque plane (64) est formée entre la couche de film coloré (4) et la seconde lentille convergente (62), et la seconde couche de plaque plane (64) est connectée à la première couche de plaque plane (63).

13. Procédé de préparation du module d'affichage selon la revendication 12, dans lequel la formation de la couche de microlentilles (6) du côté de la couche de film coloré (4) éloigné du panneau d'affichage (1) comprend : la formation d'une couche de matériau à microlentilles sur le côté de la couche de film coloré (4) éloigné du panneau d'affichage (1), puis la formation d'une couche de motif prédéfinie en réalisant un traitement de motif sur la couche de matériau à microlentilles, puis la formation de la première lentille convergente (61), de la seconde lentille convergente (62), de la première couche de plaque plane (63) et de la seconde couche de plaque plane (64) en cuisant la couche de motif prédéfinie.

14. Procédé de préparation du module d'affichage selon la revendication 13, dans lequel la température de cuisson est supérieure ou égale à 100° C et inférieure ou égale à 130° C, et la durée de cuisson est supérieure ou égale à 50 minutes et inférieure ou égale à 70 minutes.

15. Dispositif d'affichage comprenant le module d'affichage selon l'une quelconque des revendications 1 à 10.

FIG. 1

FIG. 2

FIG. 3

FIG. 4

FIG. 5

FIG. 6

| Providing a display panel | S10 |
| Forming a color film layer on a light-emitting side of the display panel, the color film layer including a plurality of light-filtering portions | S20 |
| Forming a micro-lens layer on a side of the color film layer away from the display panel, the micro-lens layer including a plurality of first converging lenses and a plurality of second converging lenses | S30 |

FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2020162355 A1

- US 2020358034 A1